(19) Europäisches Patentamt

European Patent Office

Office européen des brevets

(11) **EP 1 297 669 B1**

(12) **EUROPÄISCHE PATENTSCHRIFT**

(45) Veröffentlichungstag und Bekanntmachung des Hinweises auf die Patenterteilung:
**15.02.2006 Patentblatt 2006/07**

(51) Int Cl.:
*H04L 25/03* (2006.01)

(21) Anmeldenummer: **01956265.1**

(22) Anmeldetag: **11.06.2001**

(86) Internationale Anmeldenummer:
**PCT/DE2001/002201**

(87) Internationale Veröffentlichungsnummer:
**WO 2002/003636 (10.01.2002 Gazette 2002/02)**

(54) **VITERBI-ENTZERRUNG MITTELS VORAUSBERECHNETER METRIKINKREMENTE**

VITERBI EQUALIZATION USING PRECALCULATED METRICS INCREMENTS

DECODAGE DE VITERBI AU MOYEN D'INCREMENTS DE METRIQUE PRECALCULES

(84) Benannte Vertragsstaaten:
**DE FR GB**

(30) Priorität: **03.07.2000 DE 10032237**

(43) Veröffentlichungstag der Anmeldung:
**02.04.2003 Patentblatt 2003/14**

(73) Patentinhaber: **Infineon Technologies AG
81669 München (DE)**

(72) Erfinder:
• **BECKER, Burkhard
85737 Ismaning (DE)**
• **BOHNHOFF, Peter
81667 München (DE)**
• **YANG, Bin
81735 München (DE)**

(74) Vertreter: **Lange, Thomas
Patentanwälte
Lambsdorff & Lange
Dingolfinger Strasse 6
81673 München (DE)**

(56) Entgegenhaltungen:
**EP-A- 0 632 623**

• **RAPAHELI D ET AL: "A REDUCED COMPLEXITY ALGORITHM FOR COMBINED EQUALIZATION AND DECODING FOR CHANNELS WITH MULTIPATH, ISI OR PARTIAL RESPONSE" GLOBECOM '95. IEEE GLOBAL TELECOMMUNICATIONS CONFERENCE. SINGAPORE, NOV. 14 - 16, 1995, IEEE GLOBAL TELECOMMUNICATIONS CONFERENCE (GLOBECOM), NEW YORK, IEEE, US, Bd. 1, 14. November 1995 (1995-11-14), Seiten 83-87, XP000621460 ISBN: 0-7803-2510-9**
• **JAVAN A ERFANIAN ET AL: "REDUCED COMPLEXITY SYMBOL DETECTORS WITH PARALLEL STRUCTURES" COMMUNICATIONS: CONNECTING THE FUTURE. SAN DIEGO, DEC. 2 - 5, 1990, PROCEEDINGS OF THE GLOBAL TELECOMMUNICATIONS CONFERENCE AND EXHIBITION(GLOBECOM), NEW YORK, IEEE, US, Bd. 2, 2. Dezember 1990 (1990-12-02), Seiten 704-708, XP000220871 ISBN: 0-87942-632-2**

EP 1 297 669 B1

**Beschreibung**

Die Erfindung betrifft einen Viterbi-Entzerrer zur Entzerrung eines über einen gestörten Kanal übertragenen Datensignals sowie ein Viterbi-Entzerrungsverfahren nach den Oberbegriffen der Ansprüche 1 bis 9.

Viterbi-Entzerrer sind bereits bekannt und werden derzeit in weitem Umfang als adaptive Entzerrer im Bereich des Mobilfunks eingesetzt.

Viterbi-Entzerrer sind MLSE-(Maximum-Likelihood Sequence Estimation-)Folgenschätzer. Bei der Folgenschätzung wird auf der Basis einer detektierten Empfangsfolge $\{x_k\}$ bestehend aus L+1 Datensymbolen $x_k$, k = 0, .., L, die im folgenden auch als Abtastwerte bezeichnet werden, die von dem Sender tatsächlich gesendete Folge $\{a_k\}$ bestehend aus L+1 Datensymbolen $a_k$, k = 0, .., L, geschätzt. Die empfängerseitig geschätzte Datenfolge wird im folgenden mit $\{A_k\}$ bezeichnet. Sie besteht ebenfalls aus L+1 Datensymbolen $A_k$, k = 0, .., L, die im optimalen Fall mit den gesendeten Datensymbolen $a_k$ übereinstimmen.

Das Prinzip der MLSE-Folgenschätzung ist einfach: Werden die Übertragungseigenschaften des Übertragungskanals durch v+1 Kanalimpulsantworten $h_0$, $h_1$, .., $h_v$ beschrieben (v ist eine ganze Zahl größer oder gleich 0), so können die Abtastwerte $x_k$ gemäß

$$x_k = \sum_{l=0}^{v} a_{k-l} h_l + n_k$$

als zeitdiskrete Faltungen der gesendeten Datenfolge $\{a_k\}$ mit den Kanalimpulsantworten $h_0$, $h_1$, .., $h_v$, zuzüglich einer additiven Störung (beschrieben durch eine Folge $\{n_k\}$ bestehend aus L+1 Störwerten $n_k$, k = 0, .., L), ausgedrückt werden.

Im Empfänger sind die Abtastwerte $x_k$ als "Meßwerte" bekannt und die Kanalimpulsantworten $h_0$, $h_1$, .., $h_v$ des Kanals werden in regelmäßigen Zeitabständen geschätzt. Die geschätzten Kanalimpulsantworten werden im folgenden mit $H_0$, $H_1$, .., $H_v$ bezeichnet. Als mutmaßlich gesendete Folge wird dann diejenige L+1-elementige Datenfolge $\{A_k\}$ aller möglichen L+1-elementigen Datenfolgen bestimmt, deren Datensymbole, gewichtet mit den geschätzten Kanalimpulsantworten $H_0$, $H_1$, .., $H_v$, den geringsten Euklidschen Abstand zu der Datenfolge der gemessenen Abtastwerte $x_k$ hat. Das heißt, die Bedingung für die gesuchte Datenfolge $\{A_k\}$ lautet

$$\sum_{k=0}^{L+v} \left( x_k - \sum_{l=0}^{v} A_{k-l} H_l \right)^2 = \text{Minimum} \tag{1}$$

Die Schwierigkeit besteht darin, diese Minimierungsaufgabe aufwandsgünstig zu lösen.

Eine auf A. J. Viterbi und G. D. Forney zurückgehende rekursive Lösung der Gleichung (1) ist als Viterbi-Algorithmus bekannt. Der entscheidende Vorteil des Viterbi-Rekursionsverfahrens besteht darin, daß bei jedem Rekursionsschritt ein Großteil der prinzipiell möglichen Datenfolgen eliminiert werden kann, so daß letztlich nur ein Bruchteil aller möglichen Datenfolgen bis zum Ende der Übertragung (d.h. der Entgegennahme aller Abtastwerte $x_k$, k = 0, .., L) verfolgt werden muß.

In dem den nächstliegenden Stand der Technik repräsentierenden Buch "Entwurf und Realisierung von Viterbi-Detektoren für Mobilfunkkanäle", von P. Jung, Forschungsberichte VDI, Reihe 10, Nr. 238, VDI-Verlag, sind in den Kapiteln 5.2.3 und 5.2.4 (Seiten 91 bis 111) ein Vielzahl von Entzerrern beschrieben, deren Arbeitsweise der Viterbi-Algorithmus zugrunde liegt.

Das bekannte Viterbi-Entzerrungsverfahren wird auch im Rahmen der Erfindung genutzt und in diesem Zusammenhang kurz beschrieben.

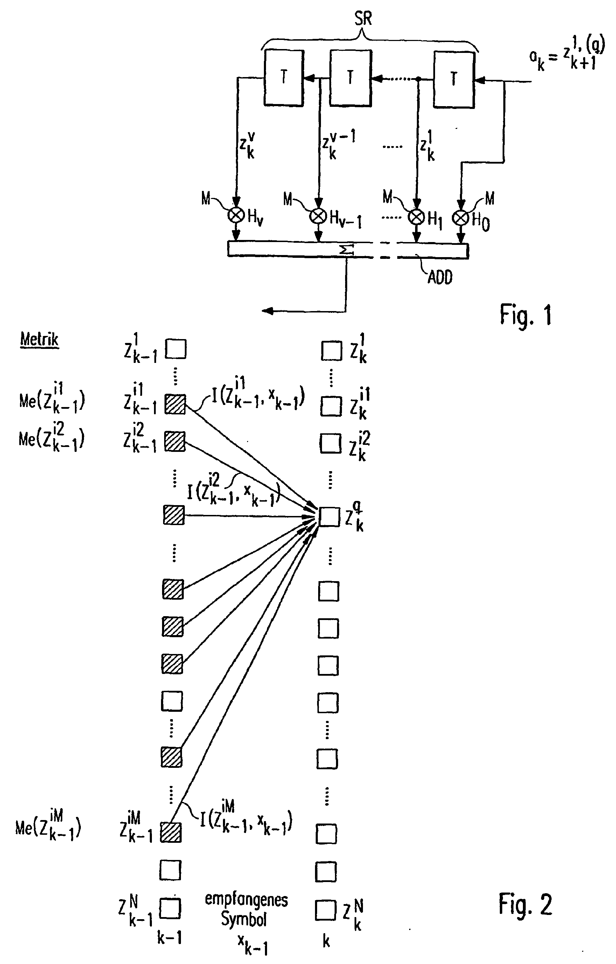

Das Viterbi-Entzerrungsverfahren basiert darauf, daß der zeitdiskrete v+1-Wege-Kanal durch einen getakteten, endlichen Automaten modelliert werden kann, siehe Fig. 1. Der Automat umfaßt ein Schieberegister SR bestehend aus v Speicherzellen T. Vor und hinter jeder Speicherzelle T befinden sich jeweils Abgriffe (insgesamt v+1 Stück), die zu Multiplizierern M führen, welche die Werte der Datensymbole mit jeweils einer der aktuell geschätzten Kanalimpulsantworten $H_0$, $H_1$, .., $H_v$ multiplizieren. Die Ausgabestufe des Automaten wird durch einen Addierer ADD realisiert, der die Ausgänge der v+1 Multiplizierer aufaddiert.

In diesem Modell wird durch die Speicherinhalte des Schieberegisters der Zustand des Kanals beschrieben. Der Speicherinhalt der eingangsseitig ersten Speicherzelle im Zeitschritt k wird mit $z_k^1$ und die Speicherinhalte der nachfolgenden Speicherzellen werden mit $z_k^2$, $z_k^3$, .., $z_k^v$ bezeichnet. Der Zustand $Z_k$ des Kanals im Zeitschritt k ist dann eindeutig durch die Angabe der Speicherinhalte, d.h. durch ein v-Tupel $Z_k = (z_k^v, .., z_k^2, z_k^1)$, bestimmt.

Zum k-ten Zeitschritt werde dem Schieberegister eingangsseitig gerade das Datensymbol $a_k$ zugeführt. Die Speicherzellen des Schieberegisters speichern in diesem Moment also die zuvor eingegebenen Datensymbole ($a_{k-v}$, .., $a_{k-2}$, $a_{k-1}$). Mit jedem Zeitschritt ändert sich im allgemeinen der Speicherinhalt einer jeden Speicherzelle, da das abgespeicherte Datensymbol in die nächste Speicherzelle geschoben wird.

Die sich dabei ergebende Folge $\{Z_k\}$ von Zuständen bestimmt einen Pfad durch einen über der diskreten Zeit kT (T bezeichnet die Symbolzeitdauer) aufgetragenen regelmäßigen Graphen. Dieser Graph heißt Trellis-Diagramm. Der Viterbi-Algorithmus ermittelt zur Schätzung der gesendeten Folge $\{a_k\}$ die Folge $\{Z_k\}$ der Zustände durch das Trellis-Diagramm. Der durch die Folge $\{Z_k\}$ bestimmte Pfad durch das Trellis-Diagramm wird auch als "kürzester" Pfad durch das Trellis-Diagramm bezeichnet.

Fig. 2 zeigt am Beispiel eines M-stufigen Datensignals (für die Darstellung wurde M = 8 gewählt) einen Ausschnitt des Trellis-Diagramms für die beiden Zeitschritte k-1 und k. Bei einem M-stufigen Datensignal existieren in jedem Zeitschritt $N = M^v$ Kanalzustände. Die N Kanalzustände zum Zeitschritt k sind mit $Z_k^1$, $Z_k^2$, .., $Z_k^N$ bezeichnet, eine entsprechende Notation wird für die N Kanalzustände zum Zeitschritt k-1 verwendet. Jeder Zustand zum Zeitschritt k kann durch M Übergänge ausgehend von M unterschiedlichen Vorgänger-Zuständen zum Zeitschritt k-1 erreicht werden. Betrachtet werden nun diejenigen M möglichen Vorgänger-Zustände zum Zeitschritt k-1, die zu einem bestimmten, mit dem Index q gekennzeichneten Zustand $Z_k^q$ zum Zeitschritt k führen. Für jeden dieser M möglichen Vorgänger-Zustände $Z_{k-1}^{i1}$, $Z_{k-1}^{i2}$, .., $Z_{k-1}^{iM}$ zum Zeitschritt k-1, die in Fig. 2 schraffiert dargestellt sind, wurde bei der vorherigen Rekursion bereits der kürzeste, auf diesen Zustand führende Pfad ermittelt. Die Frage ist, welcher dieser M Pfade, die zu den möglichen Vorgänger-Zuständen $Z_{k-1}^{i1}$, $Z_{k-1}^{i2}$, .., $Z_{k-1}^{iM}$ hinführen, derjenige ist, welcher, wenn er zu dem bestimmten Zustand $Z_k^q$ im Zeitschritt k fortgesetzt wird, den kürzesten Pfad zu diesem Zustand $Z_k^q$ aufbaut.

Zur Beantwortung dieser Frage wird beim Viterbi-Algorithmus für jeden der betrachteten Übergänge (zwischen einem der möglichen Vorgänger-Zustände $Z_{k-1}^{i1}$, $Z_{k-1}^{i2}$, .., $Z_{k-1}^{iM}$ und dem bestimmten Zustand $Z_k^q$) ein Metrikinkrement $I(Z_{k-1}^{i1}, x_{k-1})$, $I(Z_{k-1}^{i2}, x_{k-1})$, .., $I(Z_{k-1}^{iM}, x_{k-1})$ berechnet, und zwar gemäß

$$I(Z_{k-1}^i, x_{k-1}) = \left( x_{k-1} - \sum_{l=1}^{v} z_{k-1}^{1,(i)} H_l - z_k^{1,(q)} H_0 \right)^2 \qquad (2)$$

i = i1, i2, .., 1M,

wobei nach der bereits eingeführten Notation die M Vorgänger-Zustände $Z_{k-1}^i = (z_{k-1}^{v,(i)}, .., z_{k-1}^{2,(i)}, z_{k-1}^{1,(i)})$ durch die jeweilige Belegung der v Speicherzellen des Schieberegisters SR beschrieben werden und $z_k^{1,(q)}$ das Übergangssymbol zwischen den Zuständen $Z_{k-1}^i$ und $Z_k^q$ bezeichnet.

Aufgrund der rekursiven Berechnungsweise ist zum Zeitschritt k für jeden der M möglichen Vorgänger-Zustände $Z_{k-1}^{i1}$, $Z_{k-1}^{i2}$, .., $Z_{k-1}^{iM}$ bereits eine minimale Metrik $Me(Z_{k-1}^{i1})$, $Me(Z_{k-1}^{i2})$, .., $Me(Z_{k-1}^{iM})$ be-

rechnet worden. Auf der Basis dieser bekannten M minimalen Metriken $\mathrm{Me}(Z_{k-1}^{i1})$, $\mathrm{Me}(Z_{k-1}^{i2})$, ... $\mathrm{Me}(Z_{k-1}^{iM})$ für die möglichen Vorgänger-Zustände und der berechneten M Metrikinkremente $\mathrm{I}(Z_{k-1}^{i}, x_{k-1})$ für die zugehörigen Übergänge wird der Pfad-Entscheidungsprozeß für den Zeitschritt k durchgeführt. Er umfaßt drei Schritte:

- Durch einen **Additionsschritt** ("ADD") werden die mit $\mathrm{me}^{i}(Z_{k}^{q})$ bezeichneten M Kandidaten für die minimale Metrik des bestimmten Zustands $Z_{k}^{q}$ als Summe jeweils der minimalen Metrik einer der Vorgänger-Zustände und des zugehörigen Metrikinkrements nach

$$\mathrm{me}^{i}(Z_{k}^{q}) = \mathrm{Me}(Z_{k-1}^{i}) + \mathrm{I}(Z_{k-1}^{i}, x_{k-1}), \qquad i = i1, i2, ..., iM \tag{3}$$

berechnet.

- Durch einen **Vergleichsschritt** ("COMPARE") wird diejenige der M berechneten Metriken $\mathrm{me}^{i}(Z_{k}^{q})$ bestimmt, die den kleinsten Wert aufweist. Diese wird die minimale Metrik $\mathrm{Me}(Z_{k}^{q})$ des bestimmten Zustands.

- Durch einen **Auswahlschritt** ("SELECT") wird derjenige Vorgänger-Zustand der M möglichen Vorgänger-Zustände $Z_{k-1}^{i1}$, $Z_{k-1}^{i2}$, ..., $Z_{k-1}^{iM}$ ausgewählt, der Ausgangspunkt des Übergangs zum Zustand $Z_{k}^{q}$ mit der minimaler Metrik $\mathrm{Me}(Z_{k}^{q})$ ist, d.h. es wird der Index i ermittelt, für den $\mathrm{me}^{i}(Z_{k}^{q}) = \mathrm{Me}(Z_{k}^{q})$ gilt. Damit ist der "richtige" Vorgänger-Zustand bestimmt. Die Pfade, die zu den übrigen Voränger-Zuständen führen, brauchen nun nicht mehr weiter verfolgt zu werden.

Die drei genannten Schritte sind grundlegend für eine Viterbi-Entzerrung. Sie sind in der Literatur als ACS-(Add-Compare-Select)Operationen bekannt.

Es wird deutlich, daß jede ACS-Operation notwendigerweise zeitlich "rückwärts" (von k nach k-1) durchgeführt werden muß, weil sie an einen bestimmten Zielzustand zum Zeitschritt k anknüpft, jedoch Übergänge vom Zeitschritt k-1 ausgehend zu diesem bestimmten Zielzustand bewertet.

Für höherstufige Datensignale erhöht sich der Realisierungsaufwand eines Viterbi-Entzerrers drastisch. Während GSM (Global System for Mobile Communications) ein binäres (d.h. zweistufiges) Datensignal nutzt, liegt dem neuen EDGE-(Enhanced Data Services for GSM Evolution-)Standard das 8-PSK-(Phase Shift Keying-)Modulationsverfahren zugrunde, welches ein 8-stufiges Datensignal (M = 8) voraussetzt. Dies bedeutet, daß von jedem Trellis-Zustand 8 Zustands-Übergänge ausgehen und in jedem Trellis-Zustand 8 Zustands-Übergänge enden. Ein Kanal mit einem Kanalgedächtnis von z.B. v = 5 würde zu N = $8^5$ möglichen Kanalzuständen führen, für die für jeden Zeitschritt eine ACS-Operation durchzuführen wäre. Dabei müßten bei jeder ACS-Operation für einen Zielzustand die 8 möglichen Vorgänge-Zustände ermittelt und 8 Metrikinkremente berechnet werden. Der hierfür benötigte Realisierungs- bzw. Rechenaufwand ist für praktische Anwendungen zu hoch.

Es ist daher bereits vorgeschlagen worden, bei höherstufigen Datensignalen nicht alle $M^v$ Kanalzustände sondern nur einen Teil davon bei der Viterbi-Entzerrung zu berücksichtigen.

Der Erfindung liegt die Aufgabe zugrunde, einen Viterbi-Entzerrer zu schaffen, der für die Entzerrung von höherstufigen Datensignalen, insbesondere von Datensignalen gemäß dem EDGE-Standard, besonders geeignet ist. Ferner zielt die Erfindung darauf ab, ein Verfahren anzugeben, das für die Entzerrung von derartigen höherstufigen Datensignalen besonders geeignet ist.

Die Aufgabenstellung wird durch die Merkmale der unabhängigen Ansprüche gelöst.

Erfindungsgemäß werden die Metrikinkremente für die Übergänge vom Zeitschritt k zum Zeitschritt k+1 anknüpfend an einen Ausgangszustand zum Zeitschritt k zu den durch Übergänge erreichbaren Zuständen zum Zeitschritt k+1, d.h. in "Vorwärtsrichtung", berechnet. Durch diese Voraus-Berechnung der Metrikinkremente und Abspeicherung derselben kann der für Speicherzugriffe benötigte Aufwand bei der Viterbi-Entzerrung vermindert werden. Anschaulich gesprochen überwiegt der Vorteil, der sich aus der einfacheren Berechnung von Metrikinkrementen "in Vorwärtsrichtung" ergibt, den Nachteil, daß die voraus-berechneten (und ggf. auch schon nach den betrachteten Zielzuständen sortierten) Metrikinkremente bei den späteren ACS-Operationen (zum Zeitschritt k+1) gemäß den betrachteten Zielzuständen aus dem Ausgabespeicher ausgelesen werden müssen.

Mit dem Begriff Kanalzustand bzw. Zustand werden im folgenden immer die bei der ACS-Operation tatsächlich berücksichtigten Zustände (N Stück) bezeichnet. Wie bereits erwähnt, kann N dabei wesentlich kleiner als $M^v$ sein. Es können insbesondere nur N = M Zustände betrachtet werden.

Vorzugsweise werden nicht nur für einige sondern für sämtliche Zustände zum Zeitschritt k die jeweiligen Metrikinkremente vorausberechnet. Dadurch stehen noch zum Zeitschritt k sowohl die Metriken aller Zustände als auch sämtliche Metrikinkremente für die Übergänge vom Zeitschritt k zu dem Zeitschritt k+1 abrufbar bereit.

Ein bevorzugter Aufbau der Einheit zur Voraus-Berechnung und Abspeicherung von Metrikinkrementen kennzeichnet sich dadurch, daß diese eine erste Berechnungseinheit zur Berechnung von Teilbeiträgen, insbesondere Partialsummen, von Metrikinkrementen und eine zweite Berechnungseinheit zur Summation von jeweils denjenigen Teilbeiträgen, die die vorauszuberechnenden Metrikinkremente bilden, umfaßt. Dieser zweiteilige Aufbau ist günstig, da er ermöglicht, die Berechnung der Metrik-Teilbeiträge entkoppelt von der Summation der jeweiligen Teilbeiträge durchzuführen; dies wiederum ist vorteilhaft, weil die Berechnung der Metrik-Teilbeiträge in größeren zeitlichen Abständen (nämlich bei jeder Aktualisierung der geschätzten Kanalimpulsantworten) als die Summation der Teilbeiträge (die für jede Berechnung eines Metrikinkrements durchgeführt werden muß) erfolgt.

Eine vorteilhafte Auslegung der ersten Berechnungseinheit kennzeichnet sich dadurch, daß in die Berechnung eines Teilbeitrags ein, zwei oder drei Kanalimpulsantworten eingehen. Vorzugsweise wird in der zweiten Berechnungseinheit dann ein Metrikinkrement durch die Summe von sechs, drei oder zwei Teilbeiträgen gebildet.

Der Ausgabespeicher der Einheit zur Voraus-Berechnung und Abspeicherung von Metrikinkrementen weist vorzugsweise einen Teilbeitrag-Speicherabschnitt auf, in welchem neben den berechneten Metrikinkrementen auch die berechneten Teilbeiträge abspeicherbar sind. In diesem Fall ist zweckmäßig, wenn der Teilbeitrag-Speicherabschnitt zur Abspeicherung von zwei kompletten Sätzen von Teilbeiträgen ausgelegt ist. Dadurch wird ein unterbrechungsfreier Betrieb der zweiten Berechnungseinheit gewährleistet, da eine Aktualisierung der in dem einen Speicherabschnitt abgelegten Teilbeiträge zeitgleich mit Zugriffen auf den anderen Speicherabschnitt erfolgen kann.

Der erfindungsgemäße Viterbi-Entzerrer und das erfindungsgemäße Verfahren sind insbesondere für den Fall M = 8, d.h. beispielsweise den EDGE-Standard, mit Vorteil einsetzbar.

Eine besonders bevorzugte Ausgestaltung des erfindungsgemäßen Verfahrens kennzeichnet sich dadurch, daß, sobald eine ACS-Operation bezüglich eines bestimmten Zielzustands zum k-ten Zeitschritt durchgeführt wurde, unter Berücksichtigung des dabei zu diesem Zustand aufgefundenen Übergangs sämtliche Metrikinkremente ausgehend von dem bestimmten Zustand zu sämtlichen Zuständen zum k+1-ten Zeitschritt berechnet werden, und zwar noch während ACS-Operationen bezüglich weiterer Zielzustände zum Zeitschritt k durchgeführt werden. Das heißt, die Berechnung von Metrikinkrementen (für den Übergang k nach k+1) und die Durchführung der ACS-Operationen (für den Übergang k-1 nach k) ist verschränkt und erfolgt im wesentlichen gleichzeitig.

Die Erfindung wird nachfolgend anhand eines Ausführungsbeispiels unter Bezugnahme auf die Zeichnung erläutert; in dieser zeigt:

Fig. 1    ein Ersatzschaltbild eines Modells für einen Mobilfunkkanal;

Fig. 2    eine schematische Darstellung eines Ausschnitts aus einem Trellis-Diagramm für M = 8 zu den Zeitschritten k-1 und k;

Fig. 3    eine schematische Darstellung eines Zustandsübergangs zwischen den Zeitschritten k-1 und k zur Erläuterung Durchführung einer ACS-Operation und der Erzeugung von Zustandsvektoren;

Fig. 4a    eine schematische Darstellung von Zustandsübergängen von den Zeitschritten k-1 nach k und k nach k+1 zur Erläuterung der Berechnung der möglichen Zustands-Metriken bei einer ACS-Operation und der Metrikinkremente;

Fig. 4b    eine schematische Darstellung von Zustandsübergängen von den Zeitschritten k-1 nach k und k nach k+1 zur Erläuterung der Berechnung der möglichen Zustands-Metriken bei einer ACS-Operation und Metrikinkremente zu einem späteren Zeitpunkt;

Fig. 4c    eine schematische Darstellung der Zustandsübergängen von den Zeitschritten k-1 nach k und k nach k+1 zur Erläuterung der Berechnung der möglichen Zustands-Metriken bei einer ACS-Operation und Metrikinkremente zu einem noch späteren Zeitpunkt;

Fig. 5    ein Blockschaltbild einer Realisierung eines erfindungsgemäßen Viterbi-Entzerrers;

Fig. 6    eine schematische Darstellung der Partitionierung eines Ausgabespeichers der ersten Berechnungseinheit; und

Fig. 7    ein Diagramm zur Erläuterung des zeitlichen Ablaufs der Berechnungen und der Synchronisierung einer ACS-Einheit mit einem DSP und einer zweiten Berechnungseinheit.

Der folgenden Beschreibung eines erfindungsgemäßen Viterbi-Entzerrers bzw. eines erfindungsgemäßen Viterbi-Entzerrungsverfahrens wird zum Zwecke eines Beispiels der EDGE-Standard mit M = 8 und einem 8-PSK-Modulationsverfahren zugrunde gelegt. Die Erfindung beschränkt sich jedoch nicht auf Entzerrer bzw. Entzerrungsverfahren für Datensignale nach dem EDGE-Standard, d.h. die Erfindung kann u.a. auch für Datensignale mit $M \neq 8$ und/oder einer von PSK unterschiedlichen Modulationsform eingesetzt werden.

Bei dem folgenden Beispiel wird eine Kanalgedächtnislänge von v = 5 angenommen. Statt $8^5$ Zustände werden jedoch lediglich acht Zustände des Kanals berücksichtigt. Die einzelnen 8-PSK-Datensymbole werden mit PSK0, PSK1, PSK2, .., PSK7 bezeichnet. Jeder Zustand des Kanals kann demzufolge mit dem in der eingangsseitig ersten Speicherzelle T abgespeicherten Datensymbol (entspricht $z_k^1$ in Fig. 1) identifiziert werden und enthält ferner die Information über die letzten vier Vorgänger-Zustände. Ein Kanalzustand kann demnach durch einen 5-komponentigen Zustandsvektor angegeben werden:

PSKi+3,PSKi+2,PSKi+1,PSKi,<u>PSKp</u>

Dabei wird zur Vereinfachung der Notation der Index k zur Angabe des Zeitschrittes fortgelassen. Die Unterstreichung verdeutlicht das den Zustand bestimmende, zuletzt erhaltene Datensymbol PSKp, die vier nicht unterstrichenen, zuvor erhaltenen Datensymbole können als Zusatz-Information zu diesem Zustand aufgefaßt werden, die lediglich bei der Berechnung der Metrikinkremente eine Rolle spielt.

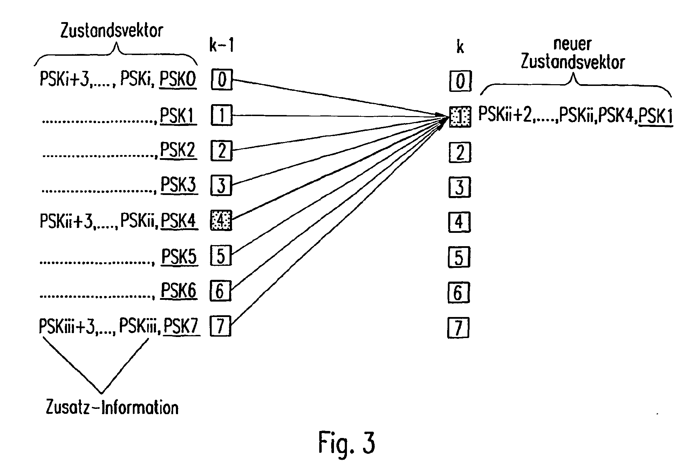

In Fig. 3 sind die acht Zustände zum Zeitschritt k-1 und die acht Zustände zum Zeitschritt k mittels von 0 bis 7 durchnummerierter Kästchen veranschaulicht. Diese Zustandsnummern werden im folgenden auch als Indizes der Zustände bezeichnet. Ferner sind die Zustandsvektoren der Zustände zum Zeitschritt k-1 angegeben. Beispielsweise wurde der Zustand mit Index 4 (entspricht <u>PSK4</u>) im Zeitschritt k-1 über die Vorgänger-Zustände PSKii, PSKii+1, PSKii+2 und PSKii+3 erreicht, d.h. der Zustandsvektor dieses Zustands lautet:

PSKii+3,PSKii+2,PSKii+1,PSKii,<u>PSK4</u>

In Fig. 3 sind die Übergänge von sämtlichen Zuständen zum Zeitschritt k-1 zu einem bestimmten Zustand zum Zeitschritt k, nämlich dem Zustand mit dem Index 1, eingezeichnet. Die Zusatz-Information zu dem bestimmten Zustand mit Index 1 zum Zeitschritt k ist abhängig von dem jeweils betrachteten Übergang, weil dieser die Zusatz-Information für diesen Zustand bestimmt. Für den mit einem dicken Pfeil kenntlich gemachten Übergang vom Zustand mit Index 4 zum Zeitschritt k-1 zum Zustand mit Index 1 zum Zeitschritt k lautet die Zusatz-Information PSKii+2,PSKii+1,PSKii,PSK4.

Das Metrikinkrement für den betrachteten Zustandsübergang berechnet sich gemäß der Gleichung (2) nach

$$I = (x_{k-1} - \sum_{j=0,1,2,3} PSKii+j \cdot H_{j+2} - PSK4 \cdot H_1 - \underline{PSK1} \cdot H_0)^2 \qquad (4)$$

Die Metrikinkremente bezüglich der Übergänge von den anderen möglichen Vorgänger-Zuständen zum Zeitschritt k-1 zu dem bestimmten Zustand mit dem Index 1 zum Zeitschritt k berechnen sich in analoger Weise.

Entsprechend der Erläuterungen zu Fig. 2 werden bei dem Additionsschritt der ACS-Operation dann die berechneten Metrikinkremente zu den bereits berechneten Metriken der Vorgänger-Zustände (zum Zeitschritt k-1) hinzuaddiert. Beim Vergleichsschritt wird diejenige neue Metrik mit dem kleinsten Wert aufgefunden. Im betrachteten Fall soll dies der Metrikwert sein, der sich bei dem fett eingezeichneten Übergang vom Zustand mit Index 4 zum Zeitschritt k-1 zum betrachteten Zustand 1 zum Zeitschritt k ergibt. Mit der Auswahl dieses "richtigen" Vorgänger-Zustands mit Zustandsvektor PSKii+3,.., PSKii,<u>PSK4</u> kann der neue Zustandsvektor des Zustandes mit Index 1 zum Zeitschritt k aufgebaut werden. Er lautet:

PSKii+2,PSKii+1,PSKii,PSK4,PSK1

Nach der Durchführung der ACS-Operationen zu sämtlichen Zuständen im Zeitschritt k sind auch sämtliche Zustandsvektoren für diese Zustände ermittelt.

In dem dargestellten Beispiel sind Übergänge zwischen sämtlichen Zuständen möglich. Dies ergibt sich zwingend aus der Tatsache, daß bei einem 8-stufigen Datensignal acht Übergänge zu jedem Zielzustand hinführen und in dem hier betrachtete vereinfachten Kanalmodell nur acht Kanalzustände berücksichtigt werden, d.h. daß für dieses Beispiel ein reduzierter Trellis mit N = M betrachtet wird.

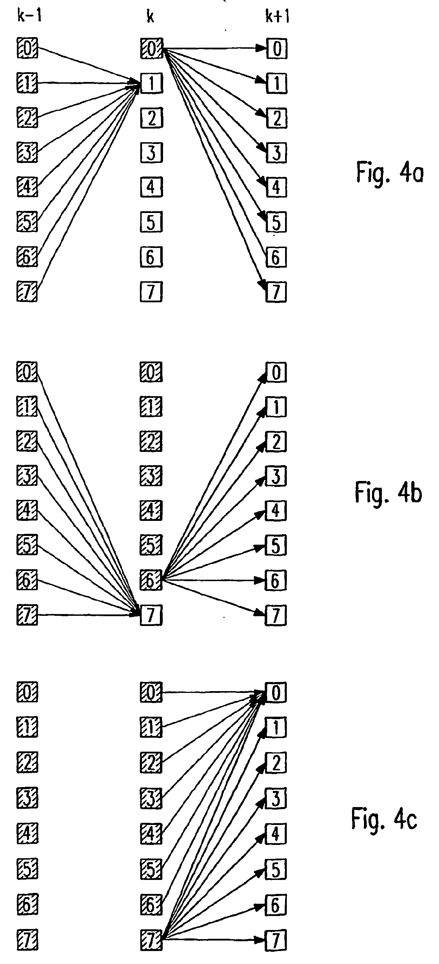

Die Fig. 4a, 4b und 4c erläutern den zeitlichen Ablauf der erfindungsgemäßen Viterbi-Entzerrung zu drei aufeinanderfolgenden Zeitpunkten. Dargestellt sind in jeder Figur die mit ihren Indizes bezeichneten Kanalzustände zu den Zeitschritten k-1, k und k+1.

Der linke Teil der Fig. 4a entspricht der Fig. 3, d.h. es werden gerade (im Rahmen des Additionsschritts der ACS-Operation) die möglichen Metriken des Zustands mit Index 1 zum Zeitschritt k berechnet. Die ACS-Operationen werden (anknüpfend jeweils an einem Zielzustand im Zeitschritt k) im zeitlichen Ablauf zu ansteigenden Indexnummern hin durchgeführt, d.h. die ACS-Operation zum Zustand mit Index 0 (zum Zeitschritt k) ist bereits erfolgt, während ACS-Operationen zu den Zuständen mit den Indizes 2, 3, .., 7 (zum Zeitschritt k) noch nicht durchgeführt wurden. Demzufolge ist der Zustandsvektor des Zustandes mit dem Index 0 (zum Zeitschritt k) bereits bekannt, während die Zustandsvektoren der restlichen Zustände (zum Zeitschritt k) noch nicht bekannt sind.

Selbstverständlich sind die Zustandsvektoren zu sämtlichen Zuständen zum Zeitschritt k-1 bereits bekannt, während die Zustandsvektoren sämtlicher Zustände zum Zeitschritt k+1 noch unbekannt sind. In den Fig. 4a bis c sind die Zustände mit bekannten Zustandsvektoren schraffiert dargestellt.

Gemäß der Erfindung werden nach der Durchführung einer ACS-Operation zu einem Zielzustand im Zeitschritt k ausgehend von diesem Zielzustand (mit nunmehr bekanntem Zustandsvektor) die acht Metrikinkremente der acht Übergänge zu den Zuständen zum Zeitschritt k+1 bestimmt. In dem in Fig. 4a dargestellten Stadium des Berechnungsablaufs werden diese Berechnungen für die Übergänge ausgehend von dem Zustand mit Index 0 zum Zeitschritt k zu den Zuständen zum Zeitschritt k+1 ausgeführt. Die Übergänge, für die Metrikinkremente berechnet werden, sind mit fetten schwarzen Pfeilen dargestellt. Die berechneten Metrikinkremente sind gleichsam "auf Vorrat" berechnet und werden zur späteren Verwendung zunächst abgespeichert. Wesentlich ist, daß die Berechnung der Metrikinkremente stets von einem festen betrachteten Ausgangszustand (hier: Zustand mit Index 0 zum Zeitschritt k) zu den acht Zielzuständen zum Zeitschritt k+1, d.h. in zeitlicher "Vorwärtsrichtung" (und damit in entgegengesetzter Richtung wie die ACS-Operation, die an einen festen Zielzustand anknüpft und Übergänge von möglichen Vorgänger-Zuständen in diesen Zielzustand betrachtet) durchgeführt wird. Der Vorteil, der sich durch diesen Berechnungsmodus ergibt, beruht im wesentlichen darauf, daß die in die Berechnung der Metrikinkremente eingehende Zusatz-Information des Ausgangszustands bei der Berechnung der Metrikinkremente in Vorwärtsrichtung für alle Übergänge die gleiche ist, während bei einer Berechnung der Metrikinkremente in "Rückwärtsrichtung" (d.h. anknüpfend an einen festen Zielzustand) stets andere Ausgangszustände zum Zeitpunkt k und somit unterschiedliche Zusatz-Informationen zu berücksichtigen wären. Dies wäre der Fall, wenn parallel zu der ACS-Operation alle Übergangsmetriken von allen Zuständen des Zeitschrittes k-1 in einen festen Zustand Zielzustand im Zeitschritt k berechnet werden müßten.

Die Berechnung der Metrikinkremente von einem Ausgangszustand zum Zeitschritt k in die Zielzustände zum Zeitschritt k+1 kann unmittelbar nach der Ermittlung des Zustandsvektors des betrachteten Ausgangszustands durch die entsprechende ACS-Operation vom Zeitschritt k-1 zum Zeitschritt k aufgenommen werden. Die Fig. 4a bis 4c verdeutlichen die zeitliche Abstimmung oder Synchronisierung dieser beiden Berechnungsprozeduren. In dem in Fig. 4b dargestellten Berechnungsstadium sind sämtliche ACS-Operationen zu den Zuständen mit Indizes 0 bis 6 zum Zeitschritt k bereits durchgeführt und die entsprechenden Zustandsvektoren sind bereits ermittelt. Bezüglich des Zustands mit Index 7 zum Zeitschritt k wird gerade der Additionsschritt der entsprechenden ACS-Operation durchgeführt. Gleichzeitig werden zu dem Zustand mit Index 6 zum Zeitschritt k die Metrikinkremente sämtlicher Übergänge zu den Zuständen zum Zeitschritt k+1 berechnet. Die Metrikinkremente bezüglich der Ausgangszustände mit den Indizes 0 bis 5 zum Zeitschritt k sind in diesem Stadium der Berechnung bereits ermittelt und abgespeichert worden.

Gemäß Fig. 4c kann die ACS-Operation für den Zielzustand mit Index 0 zum Zeitschritt k+1 bereits aufgenommen werden, während noch die Metrikinkremente von dem Ausgangszustand mit Index 7 zum Zeitschritt k zu den Zielzuständen zum Zeitschritt k+1 berechnet werden.

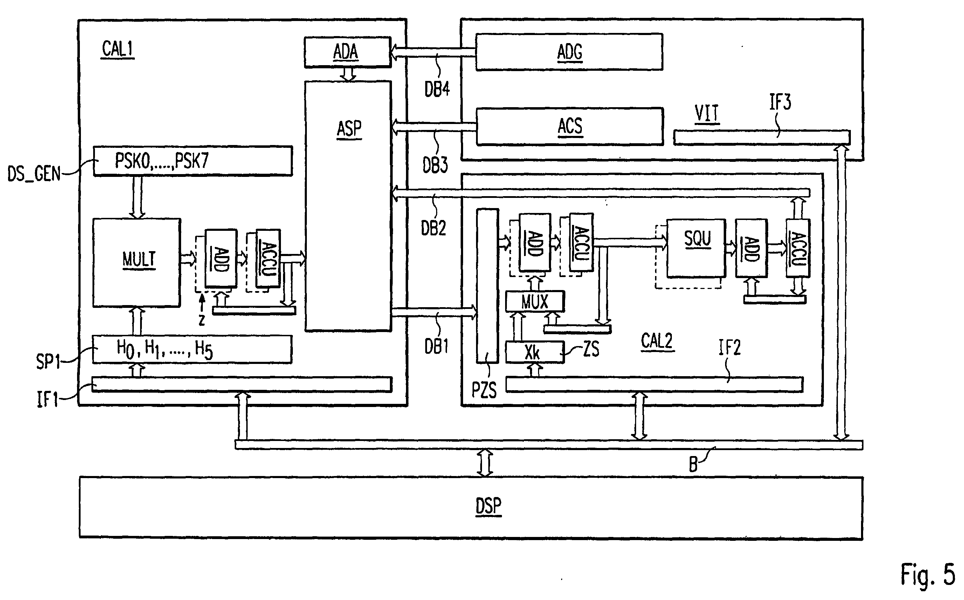

Fig. 5 zeigt ein Blockschaltbild eines Viterbi-Entzerrers gemäß der Erfindung. Der Viterbi-Entzerrer umfaßt in dem dargestellten Beispiel vier Datenverarbeitungseinheiten, nämlich einen digitalen Signalprozessor DSP, eine erste Berechnungseinheit CAL1 zur Berechnung von Partialsummen von Metrikinkrementen, eine zweite Berechnungseinheit CAL2 zur Summation geeigneter Partialsummen für die Berechnung der Metrikinkremente und eine Viterbi-Einheit VIT.

Der DSP steht über ein Bussystem B mit der ersten Berechnungseinheit CAL1, der zweiten Berechnungseinheit CAL2 und der Viterbi-Einheit VIT in bidirektionaler Datenverbindung.

Die erste Berechnungseinheit CAL1 umfaßt eine Schnittstelle IF1, einen Speicher SP1 zur Abspeicherung der geschätzten Kanalimpulsantworten $H_0$, $H_1$, .., $H_5$, einen Multiplizierer MULT, einen Datensymbol-Generator DS_GEN zur Erzeugung der 8-PSK-Datensymbole, eine Aufsummierstufe bestehend aus einem Addierer ADD und einem nachgeschalteten Akkumulator ACCU, und einen Ausgabespeicher ASP, welcher mit einer Adreßansteuerung ADA ausgerüstet ist.

In der ersten Berechnungseinheit CAL1 werden Partialsummen von Metrikinkrementen berechnet und in dem Ausgabespeicher ASP abgespeichert.

Hierzu werden der ersten Berechnungseinheit CAL1 zunächst die von dem DSP berechneten, geschätzten Kanalimpulsantworten $H_0$, $H_1$, .., $H_5$ über das Bussystem B zugeführt und in dem Speicher SP1 abgelegt.

Sobald der Transfer der Kanalimpulsantworten $H_0$, $H_1$, .., $H_5$ von dem DSP zu der ersten Berechnungseinheit CAL1 abgeschlossen ist, nimmt CAL1 die Berechnung der Partialsummen $PSKi1 \cdot H_{j+1} + PSKi0 \cdot H_j$ auf. Die Partialsummen beruhen beispielsweise jeweils auf zwei geschätzten Kanalimpulsantworten $H_{j+1}$, $H_j$ und auf zwei 8-PSK-Datensymbolen PSKi1 und PSKi0. Für die Berechnung eines ersten Satzes von Partialsummen werden zwei feste Kanalimpulsantworten herangezogen (z.B. j = 0, d.h. die beiden festen Kanalimpulsantworten sind $H_0$ und $H_1$). Jedes 8-PSK-Datensymbol PSKi1, PSKi0 kann acht verschiedene Werte annehmen. Der erste Satz von Partialsummen umfaßt daher 64 verschiedene Partialsummen.

In analoger Weise wird ein zweiter Satz von Partialsummen (z.B. zu den beiden geschätzten Kanalimpulsantworten mit j = 2) und ein dritter Satz von Partialsummen (z.B. zu den beiden geschätzten Kanalimpulsantworten mit j = 4) berechnet. Jeder Partialsummensatz umfaßt 64 Partialsummen.

Die vorstehend beschriebene Berechnung der Partialsummen wird von dem Multiplizierer MULT durchgeführt, der bei jedem Multiplikationsvorgang eine geschätzte Kanalimpulsantwort $H_0$, $H_1$, .., $H_5$ mit einem 8-PSK-Datensymbol PSK0,.., PSK7 multipliziert. Die Addition der dabei erzeugten Produktwerte erfolgt in der Aufsummierstufe ADD, ACCU. Bei der vorstehend beschriebenen Berechnung von Partialsummen bestehend jeweils aus zwei von dem Multiplizierer gelieferten Produktwerten wird die Aufsummierstufe nach Erhalt jedes zweiten Produktwertes über einen Rücksetzeingang Z auf Null gesetzt.

Allgemein können die von CAL1 berechneten Teilbeiträge zu Metrikinkrementen auch aus nur einem Produkt einer Kanalimpulsantwort und einem PSK-Datensymbol oder z.B. auch aus Partialsummen bestehend aus drei derartigen Produkten gebildet sein. Im letztgenannten Fall wird die Aufsummierstufe ADD, ACCU nach Erhalt eines jeden dritten von dem Multiplizierer MULT ausgegebenen Produktwertes zurückgesetzt. Es werden dann zwei Sätze bestehend aus jeweils 512 Partialsummen berechnet, wobei jede einzelne Partialsumme aus drei Produktwerten aufgebaut ist. Aufgrund des höheren Rechenaufwands erscheint diese Variante in der Regel jedoch ungünstiger als die Berechnung von drei Partialsummensätzen bestehend aus jeweils zwei Produktwerten pro Partialsumme. Der weiteren Beschreibung des Ausführungsbeispiels liegt daher die Berechnung von Partialsummen bestehend aus zwei Produktwerten zugrunde.

Es ist offensichtlich, daß die Anzahl der zu berechnenden Sätze von Partialsummen (unter der Voraussetzung, daß Partialsummen fester Länge betrachtet werden) von der Kanalgedächtnislänge v abhängt. Bei Berücksichtigung von acht geschätzten Kanalimpulsantworten (v = 7) wären z.B. vier Sätze von Partialsummen bestehend aus jeweils zwei Produktwerten zu berechnen. Die weitere Beschreibung, die sich an dem Beispiel v = 5 orientiert, läßt sich in offensichtlicher Weise auf die Berücksichtigung kleinerer oder größerer Kanalgedächtnislängen verallgemeinern.

Wie durch strichpunktierte Linien angedeutet, ist die Aufsummierstufe ADD, ACCU zweifach ausgeführt, um parallel die Addition des Real- und des Imaginärteils der erhaltenen Produktwerte durchführen zu können. Eine einfache Ausführung der Aufsummierstufe mit gemultiplexter Ansteuerung ist ebenfalls realisierbar.

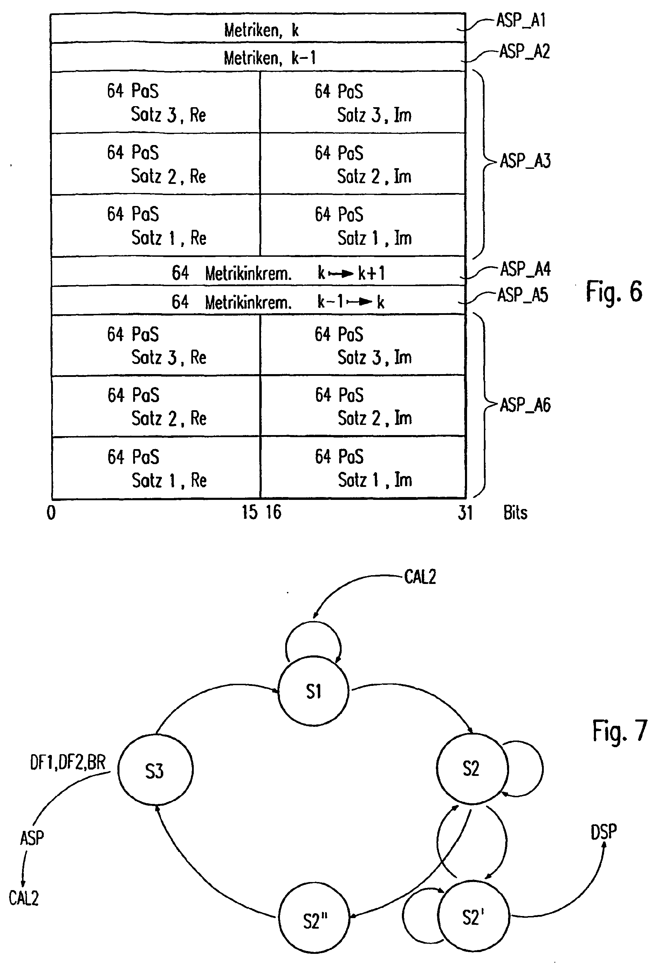

Die Abspeicherung der berechneten Partialsummensätze in dem Ausgabespeicher ASP wird anhand von Fig. 6 erläutert. Der Ausgabespeicher ASP weist zwei Speicherabschitte ASP_A3 und ASP_A6 für die berechneten Partialsummensätze auf. Während gegenwärtig verwendete Partialsummensätze beispielsweise im Speicherabschnitt ASP_A6 abgelegt sind, werden die bei einer Aktualisierung der Kanalimpulsantworten $H_0$, $H_1$, .., $H_5$ neu berechneten Partialsummensätze in den Speicherabschnitt ASP_A3 geladen. Die Partitionierung der Speicherabschnitte ASP_A6 und ASP_A3 trägt der Tatsache Rechnung, daß die Partialsummen (PaS) komplexwertig sind, d.h. daß für jede Partialsumme ein Realteil (Re, Speicher-Bits 0 bis 15) und ein Imaginärteil (Im, Speicher-Bits 16 bis 31) berücksichtigt werden müssen. Zur Abspeicherung der drei Sätze stehen drei Unterabschnitte der Speicherabschnitte ASP_A3 bzw. ASP_A6 zur Verfügung.

Die erste Berechnungseinheit braucht nicht in Hardware ausgeführt zu sein, die entsprechenden Berechnungsschritte können auch von dem DSP übernommen werden.

Die zweite Berechnungseinheit CAL2 (siehe Figur 5) zur Berechnung der Metrikinkremente erhält über einen Datenbus DB1 die Partialsummen zu den aktuellen Kanalimpulsantworten entweder von ASP_A3 oder ASP_A6 des Ausgabespeichers ASP der ersten Berechnungseinheit CAL1 und liefert letzterer über einen Datenbus DB2 die auf der Basis der erhaltenen Partialsummen berechneten Metrikinkremente für den Übergang vom Zeitschritt k zum Zeitschritt k+1, siehe die Fig. 4a bis c. Diese 64 Metrikinkremente werden in einem Speicherabschnitt ASP_A4 des Ausgabespeichers ASP abgespeichert (siehe Figur 6). Ein Speicherabschnitt ASP A5 des Ausgabespeichers ASP umfaßt die für die vorhergehenden Übergänge vom Zeitschritt k-1 zum Zeitschritt k berechneten 64 Metrikinkremente.

Zur Berechnung der betrachteten Metrikinkremente für den Übergang vom Zeitschritt k zum Zeitschritt k+1 benötigt die zweite Berechnungseinheit CAL2 einerseits den aktuellen Abtastwert $x_k$ und andererseits die "richtigen" Partialsummen zur Erzeugung dieser Metrikinkremente.

Der aktuelle Abtastwert $x_k$ wird der zweiten Berechnungseinheit CAL2 von dem DSP über das Bussystem B und eine interne Schnittstelle IF2 mitgeteilt und in einem Abtastwert-Zwischenspeicher ZS abgelegt.

Die richtigen Partialsummen (die Adressierung des Ausgabespeichers ASP zur Ausgabe dieser richtigen Partialsummen wird später erläutert) befinden sich in einem Partialsummen-Zwischenspeicher PZS der zweiten Berechnungseinheit CAL2.

Eine Aufsummierstufe bestehend aus einem Addierer ADD und einem Akkumulator ACCU summiert gemäß der Gleichung (4) jeweils drei zwischengespeicherte Partialsummen auf und greift in einem vierten Summationsschritt mittels eines Multiplexers MUX auf den zwischengespeicherten Abtastwert $x_k$ zu. Am Ausgang der Aufsummierstufe (die aufgrund der Summation komplexwertiger Größen wiederum zweifach oder einfach und gemultiplext ausgeführt sein kann) steht der in dem Klammerausdruck der Gleichung (4) angegebene Summenwert bereit.

Dieser Summenwert wird von einem Quadrierer SQU der zweiten Berechnungseinheit CAL2 quadriert. Der Quadrierer SQU kann wiederum zweifach oder einfach und zeitgemultiplext realisiert sein, um Realteil und Imaginärteil des komplexwertigen Summenwerts zu quadrieren. Eine nachgeschalteter Addierer/Akkumulator summiert die Quadrate des Real- und Imaginärteils.

Der quadrierte, reellwertige Summenwert ist eines der 64 zu berechnenden Metrikinkremente für den Übergang vom Zeitschritt k zum Zeitschritt k+1, welches sodann wie bereits beschrieben in dem Speicherabschnitt ASP_A4 des Ausgabespeichers ASP abgelegt wird.

Aufbauend auf den zuvor im ACS-Schritt ermittelten Zustandsvektoren des Zeitschritts k wird dieser Vorgang so lange wiederholt, bis sämtliche 64 Metrikinkremente für die betrachteten Übergänge vom Zeitschritt k zum Zeitschritt k+1 in Vorwärtsrichtung berechnet sind, siehe Fig. 4a-c.

Nachfolgend wird das Zusammenwirken der Viterbi-Einheit VIT mit der ersten und der zweiten Berechnungseinheit CAL1, CAL2 sowie mit dem DSP beschrieben. Die Viterbi-Einheit VIT hat im wesentlichen drei Funktionen. Sie führt die ACS-Operationen zur Ermittlung des kürzesten Pfades zu den Zielzuständen (im Zeitschritt k) durch, sie ermittelt die Zustandsvektoren der Zielzustände (zum Zeitschritt k) und sie erzeugt die Adressen für den Aufruf der richtigen Partialsummen aus dem Ausgabespeicher ASP für die zweite Berechnungseinheit CAL2.

Die Durchführung der ACS-Operationen und die Ermittlung der Zustandsvektoren wurde bereits anhand der Fig. 2 bis 4c beschrieben. Es wird nun die Erzeugung der Adressen zum Aufruf der Partialsummen erläutert:

Der in Fig. 5 dargestellte Viterbi-Entzerrer befinde sich in dem in Fig. 4a dargestellten Berechnungsstadium. Das heißt, daß der Zustand mit Index 0 zum Zeitschritt k gerade bestimmt wurde und nunmehr die ersten 8 Metrikinkremente ausgehend von diesem Zustand in die Zustände zum Zeitschritt k+1 von der zweiten Berechnungseinheit CAL2 zu berechnen sind.

Der gerade bestimmte Zustand mit Index 0 zum Zeitschritt k weise den (beliebigen) Zustandsvektor PSKf, PSKe,PSKd,PSKc,PSKb auf. Dieser Zustandsvektor ist der Viterbi-Einheit VIT bekannt, da er von letzterer soeben gerade bestimmt wurde. Die zu berechnenden Metrikinkremente von diesem Ausgangszustand zu den acht Zielzuständen zum Zeitschritt k+1 unterscheiden sich lediglich in ihrem letzten Summand, nämlich $PSKa \cdot H_0$. Dieser letzte Summand kann die folgenden Werte annehmen: $PSK0 \cdot H_0$, $PSK1 \cdot H_0$, $PSK2 \cdot H_0$, $PSK3 \cdot H_0$, $PSK4 \cdot H_0$, $PSK5 \cdot H_0$, $PSK6 \cdot H_0$, $PSK7 \cdot H_0$.

Dies bedeutet, daß die beiden Partialsummen $PSKf \cdot H_5 + PSKe \cdot H_4$ und $PSKd \cdot H_3 + PSKc \cdot H_2$ in jedem zu berechnenden Metrikinkrement auftreten. Ein Adreß-Generator ADG der Viterbi-Einheit VIT erzeugt zum Aufruf der ersten Partialsumme $PSKf \cdot H_5 + PSKe \cdot H_4$ eine Adresse DF2 und er erzeugt zum Aufruf der zweiten Partialsumme $PSKd \cdot H_3 + PSKc \cdot H_2$ eine Adresse DF1. Darüber hinaus erzeugt der Adreß-Generator ADG acht weitere Adressen BR zum Aufruf der jeweiligen Partialsummen im letzten Summanden der zu berechnenden Metrikinkremente. Die Adressen werden der Adreßansteuerung ADA des Ausgabespeichers ASP über einen Adreßdatenbus DB4 mitgeteilt. Demzufolge werden zehn Partialsummen-Speicheraufrufe benötigt, um die in Fig. 4a gezeigten acht Metrikinkremente zu berechnen. Die Berechnung sämtlicher 64 in dem Speicherabschnitt ASP_A4 abzulegenden Metrikinkremente erfordert somit 80 Partialsummen-Speicheraufrufe.

Nach der Berechnung dieser 64 Metrikinkremente werden die ACS-Operationen zu den Zielzuständen zum Zeitschritt k+1 durchgeführt und dabei die zugehörigen Zustandsvektoren ermittelt. Um bei der in den Fig. 4a bis c gewählten Darstellung zu bleiben, werden stattdessen die zu Zielzuständen zum Zeitschritt k führenden ACS-Operationen betrachtet.

Zur Durchführung dieser ACS-Operationen greift die ACS-Einheit ACS auf die Speicherabschnitte ASP_A5 und einen Speicherbereich ASP_A2 des Ausgabespeichers ASP zu. In dem Speicherabschnitt ASP_A2 sind die im vorhergehenden Zeitschritt berechneten Metriken der Zustände zum Zeitschritt k-1 abgespeichert. Für jede ACS-Operation (zu einem bestimmten Zielzustand zum Zeitschritt k) werden die zugehörigen acht Metrikinkremente und die zugehörigen acht Metriken der Vorgänger-zustände ausgelesen und zur Bestimmung des Zielzustandes in der bereits beschriebenen Weise addiert, verglichen und selektiert. Somit sind zu der Bestimmung der acht Zielzustände zum Zeitschritt k pro ACS-Operation sechzehn Speicherzugriffe erforderlich. Für die Bestimmung sämtlicher Zielzustände zum Zeitschritt k werden daher 8 (ACS-Operationen) x 16 (Speicherzugriffe) = 128 Speicherzugriffe benötigt.

Die im Rahmen der ACS-Operationen berechneten Metriken der Zielzustände werden über einen Datenbus DB3 einem Speicherbereich ASP_A1 des Ausgabespeichers ASP zugeleitet und dort abgespeichert.

Aus der vorhergehenden Beschreibung wird deutlich, daß erfindungsgemäß für die gesamte Berechnungsprozedur zur Bestimmung der acht Zustände zu einem Zeitschritt 80 Partialsummen-Zugriffe durch CAL2 und 64 Metrikinkrement-Zugriffe sowie 64 Metrik-Zugriffe durch die ACS-Einheit ACS durchzuführen sind. Es ergeben sich insgesamt 208 Speicherzugriffe auf den Ausgabespeicher ASP.

Gemäß der herkömmlichen Vorgehensweise würden die Übergangsmetriken zu dem Zeitpunkt (bzw. Zeitschritt) berechnet, zu dem die ACS-Einheit diese zur Berechnung der Metriken braucht. Für 8 Zustände, 8 Übergänge zu jedem Zustand und 3 Speicherzugriffe zum Adressieren der Partialsummen wären 192 Speicherzugriffe erforderlich (im Vergleich zu 80 Speicherzugriffen der erfindungsgemäßen Vorgehensweise).

Werden die Metrikinkremente nicht parallel zur ACS-Berechnung berechnet und abgespeichert, würde sich der Entzerrungsprozeß um den Faktor 192/80 = 2,4 verlangsamen, was in der Praxis aufgrund systembedingter Vorgaben nicht zulässig ist.

Ein Abspeichern und Auslesen der Metrikinkremente erhöht die Zahl der Speicherzugriffe gemäß der herkömmlichen Vorgehensweise von 192 auf 192 + 64 + 64 = 320. Mit 64 Metrikzugriffen steht die Zahl notwendiger Speicherzugriffe gemäß der herkömmlichen Vorgehensweise von 320 einer Zahl von 208 gemäß der erfindungsgemäßen Vorgehensweise gegenüber.

Ganz offensichtlich wird der Unterschied in der Zugriffsrate, wenn lediglich Teilbeiträge bestehend aus einem Produktterm (der Form PSKij·Hj) zur Entlastung der ersten Berechnungseinheit CAL1 berechnet werden.

Die von der Viterbi-Einheit VIT anhand der ermittelten kürzesten Pfade bestimmten 8-PSK-Datensymbole werden in Form von weichen Ausgabewerten über eine Schnittstelle IF3 dem DSP mitgeteilt. Es werden für jedes geschätzte 8-PSK-Datensymbol drei wertekontinuierliche Schätzwerte für drei Bits einer Binärdarstellung des geschätzten Datensymbols erzeugt.

Anhand der Fig. 7 wird die Synchronisierung der Viterbi-Einheit VIT mit der zweiten Berechnungseinheit CAL2 und dem DSP erläutert.

In einem Stadium S1 des Berechnungsablaufs wartet die Viterbi-Einheit VIT das Ende einer Voraus-Berechnung sämtlicher acht Metrikinkremente für die Übergänge von einem bestimmten Ausgangszustand mit Index i-1 zum Zeitschritt k ab. Wenn diese Metrikinkremente berechnet und im Speicherabschnitt ASP_A4 abgelegt sind, wird in dem Stadium S2 des Berechnungsablaufs eine ACS-Operation bezüglich des nächsten (Ziel-)Zustands mit dem Index i+1 zum Zeitschritt k durchgeführt. Parallel dazu werden in der zweiten Berechnungseinheit CAL2 die Metrikinkremente für die Übergänge von dem Zustand mit dem Index i zum Zeitschritt k berechnet. Im Rahmen der ACS-Operation werden in einer Berechnungsschleife S2' die drei weichen Ausgabewerte für ein PSK-Datensymbol berechnet und dem DSP nach Abarbeitung einer Zeiteinheit zugeführt. Parallel dazu wird in einer Berechnungsprozedur S2'' der neue Zustandsvektor zu dem betrachteten Zielzustand berechnet.

Im Stadium S3 des Berechnungsablaufs werden auf der Basis des neuen Zielzustands die Adressen DF2, DF1 und die 8 Adressen BR zum Aufruf der Partialsummen für die Übergänge vom Zustand i+1 des Zeitschritts k erzeugt. In diesem Ablaufstadium erfolgt eine Synchronisierung der Viterbi-Einheit VIT mit der zweiten Berechnungseinheit CAL2, die die adressierten Partialsummen entgegennimmt. Die Viterbi-Einheit VIT wartet im Stadium S1, bis die zweite Berechnungseinheit CAL2 in der bereits beschriebenen Weise die acht Metrikinkremente von dem bestimmten Ausgangszustand mit Index i zum Zeitschritt k berechnet hat. Wenn die acht Metrikinkremente berechnet sind, wird der Wartezustand der Viterbi-Einheit VIT aufhoben (Stadium S1), was wiederum eine Synchronisierung zwischen CAL2 und VIT bedeutet. Nachfolgend berechnet CAL2 die Übergangsmetriken vom Zustand i+1 des Zeitschrittes k, während VIT die Metrik und den Zustandsvektor des Zustands i+2 des Zeitschrittes k berechnet.

Durch den erläuterten Aufbau wird erreicht, daß die zweite Berechnungseinheit CAL2, nicht aber die erste Berechnungseinheit CAL1, mit der Viterbi-Einheit VIT synchronisiert werden muß. Es ist jedoch ohne weiteres denkbar, die beiden Berechnungseinheiten CAL1 und CAL2 zu einer Einheit zusammenzufassen. Ferner muß der Ausgabespeicher ASP nicht Bestandteil der ersten Berechnungseinheit CAL1 sein, sondern kann an anderer Stelle im Blockschaltbild der Fig. 5 positioniert sein. Ferner können die einzelnen Speicherabschnitte bzw. Unterabschnitte des Ausgabespeichers ASP beispielsweise auch in Form von separaten Speicherelementen realisiert sein.

**Patentansprüche**

**1.** Viterbi-Entzerrer zur Entzerrung eines über einen gestörten Kanal übertragenen Datensignals, mit

- zumindest einer ACS-Einheit (ACS), die zu einem jeden Kanalzustand zum Zeitschritt k durch Ausführung einer ACS-Operation denjenigen Zustandsübergang ermittelt, der mit minimaler Metrik von einem der möglichen Vorgänger-Zustände zum Zeitschritt k-1 zu dem betrachteten Zielzustand zum Zeitschritt k führt,

**dadurch gekennzeichnet,**

- **daß** eine Einheit (CAL1, CAL2) zur Voraus-Berechnung und Abspeicherung von Metrikinkrementen vorgesehen ist, die

-- die Metrikinkremente für sämtliche Übergänge ausgehend von einem gegebenen Zustand zum Zeitschritt k zu den durch die Übergänge jeweils erreichbaren Zustände im Zeitschritt k+1 berechnet, und
-- in einem Ausgabespeicher (ASP) abrufbar für die ACS-Einheit (ACS) zur Durchführung der ACS-Operationen zu den Zielzuständen im Zeitschritt k+1 bereithält.

2. Viterbi-Entzerrer nach Anspruch 1,
**dadurch gekennzeichnet,**

- **daß** die Einheit (CAL1, CAL2) zur Voraus-Berechnung und Abspeicherung von Metrikinkrementen die jeweiligen Metrikinkremente für sämtliche Zustände zum Zeitschritt k vorausberechnet.

3. Viterbi-Entzerrer nach Anspruch 1 oder 2,
**dadurch gekennzeichnet,**

- **daß** die Einheit (CAL1, CAL2) zur Voraus-Berechnung und Abspeicherung von Metrikinkrementen

-- eine erste Berechnungseinheit (CAL1) zur Berechnung von Teilbeiträgen, insbesondere Partialsummen, von Metrikinkrementen, und eine
-- zweite Berechnungseinheit (CAL2) zur Summation von jeweils denjenigen Teilbeiträgen, die die vorauszuberechnenden Metrikinkremente bilden,

umfaßt.

4. Viterbi-Entzerrer nach Anspruch 3,
**dadurch gekennzeichnet,**

- **daß** in die Berechnung eines Teilbeitrags ein, zwei oder drei Kanalimpulsantworten eingehen.

5. Viterbi-Entzerrer nach Anspruch 3 oder 4,
**dadurch gekennzeichnet,**

- **daß** ein Metrikinkrement durch die Summe von sechs, drei oder zwei Teilbeiträgen gebildet wird.

6. Viterbi-Entzerrer nach einem der Ansprüche 3 bis 5,
**dadurch gekennzeichnet,**

- **daß** der Ausgabespeicher (ASP) einen Teilbeitrag-Speicherabschnitt (ASP_A3, ASP_A6) aufweist, in welchem die berechneten Teilbeiträge abspeicherbar sind.

7. Viterbi-Entzerrer nach Anspruch 6,
**dadurch gekennzeichnet,**

- **daß** der Teilbeitrag-Speicherabschnitt (ASP_A3, ASP_A6) ausgelegt ist, zwei komplette, Übergängen zwischen unterschiedlichen Zeitschritten zugeordnete Sätze von Teilbeiträgen abzuspeichern.

8. Viterbi-Entzerrer nach einem der vorhergehenden Ansprüche,
**dadurch gekennzeichnet,**

- **daß** das Datensignal 8-stufig, insbesondere ein 8-PSK-Datensignal, ist.

9. Verfahren zur Entzerrung eines über einen gestörten Kanal übertragenen Datensignals,

- wobei zur Entzerrung des Datensignals der Viterbi-Algorithmus eingesetzt wird,

**dadurch gekennzeichnet,**

- **daß** für sämtliche Übergänge zwischen einem gegebenen Zustand zu einem Zeitschritt k zu den von diesem Zustand erreichbaren Zuständen zum Zeitschritt k+1 die zugehörigen Metrikinkremente berechnet und in einem Ausgabespeicher (ASP) abgelegt werden, und
- **daß** bei der nachfolgenden Durchführung einer ACS-Operation zur Ermittlung desjenigen Übergangs, der mit minimaler Metrik von einem der möglichen Vorgänger-Zustände zum Zeitschritt k zu einem bestimmten Zielzustand zum Zeitschritt k+1 führt, die zur Durchführung der ACS-Operation benötigten Metrikinkremente aus dem Ausgabespeicher (ASP) abgerufen werden.

10. Verfahren nach Anspruch 9,
    **dadurch gekennzeichnet,**

    - **daß**, sobald eine ACS-Operation bezüglich eines bestimmten Zielzustands zum k-ten Zeitschritt durchgeführt wurde, unter Berücksichtigung des dabei zu diesem Zustand aufgefundenen Übergangs sämtliche Metrikinkremente ausgehend von dem bestimmten Zustand zu sämtlichen Zuständen zum k+1-ten Zeitschritt berechnet werden, und zwar noch während ACS-Operationen bezüglich weiterer Zustände zum Zeitschritt k durchgeführt werden.

11. Verfahren nach Anspruch 10,
    **dadurch gekennzeichnet,**

    - **daß** die Berechnung sämtlicher Metrikinkremente ausgehend von einem bestimmten Zustand zum Zeitschritt k zu sämtlichen Zuständen zum k+1-ten Zeitschritt abgeschlossen wird, bevor die Durchführung einer ACS-Operation für einen nächsten Zielzustand zum Zeitschritt k aufgenommen wird.

12. Verfahren nach einem der Ansprüche 9 bis 11,
    **dadurch gekennzeichnet,**

    - **daß** zunächst Teilbeiträge, insbesondere Partialsummen, von Metrikinkrementen berechnet und abgespeichert werden, und
    - **daß** zur Berechnung derjenigen Metrikinkremente, die den Übergängen von dem gegebenen Zustand zum Zeitschritt k zu den von diesem Zustand erreichbaren Zuständen zum Zeitschritt k+1 zugeordnet sind, die hierfür benötigten, abgespeicherten Teilbeiträge aufgerufen werden.

**Claims**

1. Viterbi equalizer for equalization of a data signal which is transmitted via a channel which is subject to interference, having

   - at least one ACS unit (ACS), which, with reference to each channel state relating to the time step k carries out an ACS operation to determine that state transition which with minimal metrics leads from one of the possible predecessor states relating to the time step k-1 to the destination state under consideration relating to the time step k,

   **characterized**

   - **in that** a unit (CAL1, CAL2) is provided for calculation in advance and for storage of metric increments, which

     -- calculates the metric increments for all the transitions starting from a given state relating to the time step k to the states which can in each case be achieved by the transitions in the time step k+1, and
     -- keeps the metric increments in an output memory (ASP) so that they can be called up for the ASC unit (ACS) for carrying out the ACS operations with respect to the destination states in the time step k+1.

2. Viterbi equalizer according to Claim 1,

**characterized**

- **in that**, for calculation in advance and for storage of metric increments, the unit (CAL1, CAL2) calculates in advance the respective metric increments for all the states relating to the time step k.

3. Viterbi equalizer according to Claim 1 or 2,
   **characterized**

   - **in that**, for calculation in advance and for storage of metric increments, the unit (CAL1, CAL2) comprises

     -- a first calculation unit (CAL1) for calculating partial amounts, in particular partial sums, of metric increments, and a
     -- second calculation unit (CAL2) for addition in each case of those partial amounts which form the metric increments to be calculated in advance.

4. Viterbi equalizer according to Claim 3,
   **characterized**

   - **in that** one, two or three channel impulse responses is or are included in the calculation of a partial amount.

5. Viterbi equalizer according to Claim 3 or 4,
   **characterized**

   - **in that** a metric increment is formed by the sum of six, three or two partial amounts.

6. Viterbi equalizer according to one of Claims 3 to 5,
   **characterized**

   - **in that** the output memory (ASP) has a partial amount memory section (ASP_A3, ASP_A6) in which the calculated partial amounts can be stored.

7. Viterbi equalizer according to Claim 6,
   **characterized**

   - **in that** the partial amount memory section (ASP_A3, ASP_A6) is designed to store two complete sets of partial amounts which are associated with transitions between different time steps.

8. Viterbi equalizer according to one of the preceding claims,
   **characterized**

   - **in that** the data signal has 8 steps, and in particular is an 8-PSK signal.

9. Method for equalization of a data signal which is transmitted via a channel which is subject to interference

   - in which the Viterbi algorithm is used for equalization of the data signal,

   **characterized**

   - **in that**, for all the transitions between a given state and a time step k and the states which can be reached from this state relating to the time step k+1, the associated metric increments are calculated and are stored in an output memory (ASP), and
   - **in that**, when an ACS operation is subsequently carried out in order to determine that transition which leads with the minimum metrics from one of the possible predecessor states relating to the time step k to a specific destination state relating to the time interval k+1, the metric increments which are required to carry out the ACS operation are called up from the output memory (ASP).

10. Method according to Claim 9,
    **characterized**

- **in that**, as soon as an ACS operation relating to a specific destination state relating to the k-th time step has been carried out, taking account of the transition which is in this case found to this state, all the metric increments are calculated starting from the specific state to all the states relating to the k+1-th time step, to be precise they are carried out even during ACS operations relating to further states relating to the time step k.

**11.** Method according to Claim 10,
   **characterized**

- **in that** the calculation of all the metric increments starting from a specific state relating to the time step k to all the states relating to the k+1-th time step is completed before starting to carry out an ACS operation for a subsequent destination state relating to the time step k.

**12.** Method according to one of Claims 9 to 11,
   **characterized**

- **in that** partial amounts, in particular partial sums, of metric increments are first of all calculated and are stored, and
- **in that** the stored partial amounts which are required for this purpose are called up in order to calculate those metric increments which are associated with the transitions from the given state relating to the time step k to the states which can be reached from this state relating to the time step k+1.

**Revendications**

**1.** Egalisateur de Viterbi pour l'égalisation d'un signal de données, transmis par une voie perturbée, comprenant

- au moins une unité ACS (ACS), qui détermine pour chaque état de voie au stade temporel k par exécution d'une opération ACS la transition d'état qui mène, avec la métrique minimum de l'un des états précédents possibles au stade temporel k-1 à l'état visé considéré au stade temporel k,

   **caractérisé**

- **en ce qu'**il est prévu une unité (CAL1, CAL2) de calcul préalable et de mémorisation d'incréments métriques, qui

   -- calcule les incréments métriques pour l'ensemble des transitions à partir d'un état donné au stade temporel k menant aux états que l'on peut atteindre respectivement par les transitions au stade temporel k+1, et
   -- les garde à disposition dans une mémoire (ASP) de distribution avec possibilité pour l'unité ACS (ACS) de les appeler pour effectuer les opérations ACS vers les états visés au stade temporel k+1.

**2.** Egalisateur de Viterbi suivant la revendication 1,
   **caractérisé**

- **en ce que** l'unité (CAL1, CAL2) calcule à l'avance, pour le calcul à l'avance et la mémorisation d'incréments métriques, les incréments métriques respectifs pour tous les états au stade temporel k.

**3.** Egalisateur de Viterbi suivant la revendication 1 ou 2,
   **caractérisé**

- **en ce que** l'unité (CAL1, CAL 2) comprend, pour le calcul préalable et à la mémorisation d'incréments métriques

   -- une première unité (CAL1) de calcul de contributions partielles, notamment de sommes partielles d'incréments métriques et
   -- une deuxième unité (CAL2) de calcul pour faire la somme des contributions partielles respectives qui forment les incréments métriques à calculer au préalable.

**4.** Egalisateur de Viterbi suivant la revendication 3,
   **caractérisé**

- **en ce qu'**il entre dans le calcul d'une contribution partielle deux ou trois réponses impulsionnelles de voie.

**5.** Egalisateur de Viterbi suivant la revendication 3 ou 4,
**caractérisé**

- **en ce qu'**un incrément métrique est formé par la somme de six, trois ou deux contributions partielles.

**6.** Egalisateur de Viterbi suivant l'une des revendications 3 à 5,
**caractérisé**

- **en ce que** la mémoire (ASP) de distribution comporte une partie de mémoire de contribution partielle (APS_A3, ASP_A6), dans laquelle les contributions partielles calculées peuvent être mémorisées.

**7.** Egalisateur de Viterbi suivant la revendication 6,
**caractérisé**

- **en ce que** la partie de mémoire de contribution partielle (APS_A3, ASP_A6) est conçue pour mémoriser deux transitions complètes entre des jeux de contributions partielles associés à des stades temporels différents.

**8.** Egalisateur de Viterbi suivant l'une des revendications précédentes,
**caractérisé**

- **en ce que** le signal de données est un signal de données à huit états, notamment un signal de données 8-PSK.

**9.** Procédé d'égalisation d'un signal de données transmis par une voie perturbée,

- dans lequel on utilise pour l'égalisation du signal de données l'algorithme de Viterbi,

**caractérisé**

- **en ce que** l'on calcule et mémorise dans une mémoire (ASP) de distribution pour l'ensemble des transitions entre un état donné à un stade temporel k et les états pouvant être atteints à partir de cet état au stade temporel k+1 les incréments métriques associés et
- **en ce que**, lorsque l'on effectue une opération ACS pour déterminer la transition qui mène, avec une métrique minimum, de l'un des états précédents possibles au stade temporel k à un état visé déterminé au stade temporel k+1, on appelle dans la mémoire (ASP) de distribution les incréments métriques nécessaires pour effectuer l'opération ACS.

**10.** Procédé suivant la revendication 9,
**caractérisé**

- **en ce que** dès qu'une opération ACS concernant un état visé déterminé a été effectuée au k-ième stade temporel, en tenant compte de la transition trouvée pour cet état, on calcule l'ensemble des incréments métriques en partant de l'état déterminé pour aller à tous les états au k+1-ième stade temporel et cela encore pendant que l'on effectue des opérations ACS concernant d'autres états au stade temporel k.

**11.** Procédé suivant la revendication 10,
**caractérisé**

- **en ce que** l'on met fin au calcul de tous les incréments métriques à partir d'un certain état au stade temporel k vers l'ensemble des états au k+1-ième stade temporel, avant d'effectuer l'opération ACS pour un état visé suivant au stade temporel k.

**12.** Procédé suivant l'une des revendications 9 à 11,
**caractérisé**

- **en ce que** l'on calcule et l'on mémorise d'abord des contributions partielles, notamment des sommes partielles d'incréments métriques et

- **en ce que**, pour le calcul des incréments métriques qui sont associés aux transitions de l'état donné au stade temporel k aux états que l'on peut atteindre à partir de cet état au stade temporel k+1, on appelle les contributions partielles mémorisées qui sont nécessaires à cet effet.

Fig. 1

Fig. 2

Fig. 3

Fig. 4a

Fig. 4b

Fig. 4c

Fig. 5

EP 1 297 669 B1

| | | |
|---|---|---|
| Metriken, k | | ASP_A1 |
| Metriken, k−1 | | ASP_A2 |
| 64 PoS Satz 3, Re | 64 PoS Satz 3, Im | |
| 64 PoS Satz 2, Re | 64 PoS Satz 2, Im | ASP_A3 |
| 64 PoS Satz 1, Re | 64 PoS Satz 1, Im | |
| 64 Metrikinkrem. k ⟼ k+1 | | ASP_A4 |
| 64 Metrikinkrem. k−1 ⟼ k | | ASP_A5 |
| 64 PoS Satz 3, Re | 64 PoS Satz 3, Im | |
| 64 PoS Satz 2, Re | 64 PoS Satz 2, Im | ASP_A6 |
| 64 PoS Satz 1, Re | 64 PoS Satz 1, Im | |

0   15 16   31   Bits

**Fig. 6**

CAL2

S1

DF1,DF2,BR

S3

S2

ASP

CAL2

S2"

S2'

DSP

**Fig. 7**